# EUROPEAN PATENT APPLICATION

(11) **EP 3 176 793 A1**
(43) Date of publication of application: **07.06.2017**
(21) Application number: 15857396.4
(22) Date of filing: 05.11.2015
(51) Int. Cl.: H01B 12/06, C01G 1/00, C01G 3/00, H01B 13/00, H01F 6/06

(54) **OXIDE SUPERCONDUCTOR, SUPERCONDUCTING WIRE, AND MANUFACTURING METHOD THEREFOR**

(30) Priority: 05.11.2014 JP 2014225285
(71) Applicant: Fujikura Ltd., Tokyo 135-8512 (JP)
(72) Inventor: ADACHI Yutaka, Sakura-shi Chiba 285-8550 (JP)
(74) Representative: Cabinet Plasseraud
(86) International application number: PCT/JP2015/081234
(87) International publication number: WO 2016/072476

(57) **Abstract**

An oxide superconductor has a composition expressed by REₐBa_{b}Cu₃O₇₋ₓ, where RE represents one rare earth or a combination of two or more of a rare earth, a satisfies 1.05 ≤ a ≤ 1.35, b satisfies 1.80 ≤ b ≤ 2.05, and x represents an amount of oxygen deficiency, and a non-superconducting phase having an outer diameter of 30 nm or less is included in a superconducting phase.

## Description

### TECHNICAL FIELD

The present invention relates to an oxide superconductor, a superconducting wire, and a method of manufacturing the same.

Priority is claimed on Japanese Patent Application No. 2014-225285, filed November 5, 2014, the content of which is incorporated herein by reference.

### BACKGROUND ART

An RE123-based oxide superconductor has a composition represented by RE₁Ba₂Cu₃O₇₋ₓ (RE: rare earth elements such as Y and Gd) and have a critical temperature higher than the temperature of liquid nitrogen (77K) (see, for example, Patent Document 1). Research for applying oxide superconductors to various superconducting devices such as superconducting magnets, transformers, current-limiting devices, and motors are being conducted in various places.

Generally, a superconductor formed to have superior crystallinity using an RE123-based oxide superconductor exhibits strong critical current characteristics in a self-magnetic field. However, when a Lorentz force acts on a quantized magnetic flux which has intruded into the superconductor and the quantized magnetic flux is moved, a voltage is generated in a current direction, and a resistance is generated. Since the Lorentz force increases as the current value increases and the magnetic field intensifies, the critical current (Ic) characteristics degrade when an external magnetic field becomes strong.

In order to improve the Ic characteristics, introducing artificial pinning centers into a superconducting layer is actively tried (see Patent Document 2). Many cases of the temperature of liquid nitrogen have been reported; however, not many favorable cases of a lower temperature and a high magnetic field have been reported.

### PRIOR ART DOCUMENTS

### PATENT DOCUMENTS

[Patent Document 1] Japanese Unexamined Patent Application, First Publication No. S63-230565
[Patent Document 2] Japanese Unexamined Patent Application, First Publication No. 2008-130291

### DISCLOSURE OF INVENTION

### PROBLEMS TO BE SOLVED BY THE INVENTION

By introducing the artificial pinning centers, although the Ic characteristics in a magnetic field are improved, it is difficult to uniformly introduce substances different from constituents of the superconducting layer into the superconducting layer. When manufacturing a long superconducting wire, the characteristics tend to vary in a longitudinal direction. This is one of the reasons that a superconducting wire which is longitudinally uniform and has the high characteristics in a magnetic field is not widespread commercially.

The present invention has been made in view of the above circumstances, and it is provided that without introducing a substance which is different from the components constituting the superconducting layer into the superconducting layer, an oxide superconductor, a superconducting wire, and a method of manufacturing the same which are capable of increasing Ic characteristics in a magnetic field, particularly in a high magnetic-field region in a low temperature.

### MEANS FOR SOLVING THE PROBLEMS

A first aspect of the present invention is an oxide superconductor having a composition expressed by REₐBa_{b}Cu₃O₇₋ₓ, where RE represents one rare earth or a combination of two or more of a rare earth, a satisfies 1.05 ≤ a ≤ 1.35, b satisfies 1.80 ≤ b ≤ 2.05, and x represents an amount of oxygen deficiency, and a non-superconducting phase having an outer diameter of 30 nm or less is included in a superconducting phase.

A second aspect of the present invention is that in the first aspect of the oxide superconductor described above, the RE is one or a combination of two or more of Y, Gd, Eu and Sm.

A third aspect of the present invention is an oxide superconducting wire includes a base material, an intermediate layer, an oxide superconducting layer including the oxide superconductor according to the first or second aspect described above, and a stabilization layer, which are sequentially laminated.

A fourth aspect of the present invention is that in the third aspect of the oxide superconducting wire described above, the non-superconducting phase is dispersed on a plane orthogonal to a laminate direction.

A fifth aspect of the present invention is a method of manufacturing the oxide superconducting wire according to the third or fourth aspect described above, the method including forming the oxide superconductor on a film formation surface of the base material by a pulse laser deposition method.

A sixth aspect of the present invention is that in the fifth aspect of the method of manufacturing the oxide superconducting wire described above, the method includes direct heating the film formation surface during forming the oxide superconductor.

### EFFECTS OF THE INVENTION

According to the aspects of the present invention described above, without introducing a substance which is different from the components constituting the superconducting layer into the superconducting layer, it is possible to provide an oxide superconductor, a superconducting wire, and a method of manufacturing the same which are capable of increasing Ic characteristics in a magnetic field, particularly in a high magnetic-field region in a low temperature. Since a different phase substance is not introduced, a superconducting wire which is uniform over a long distance and has high characteristics in a magnetic field can be easily manufactured.

### BRIEF DESCRIPTION OF THE DRAWINGS

Fig. 1 is a partial cross-sectional perspective view showing an RE123-based superconductor wire according to the first embodiment of the present invention.
Fig. 2 is an AFM image showing one example of the oxide superconductor.
Fig. 3 is a STEM image showing one example of the oxide superconductor.
Fig. 4 is an EDS image showing one example of the oxide superconductor.

### EMBODIMENTS FOR CARRYING OUT THE INVENTION

Hereinbelow, with reference to a preferred embodiment, the present invention will be described.

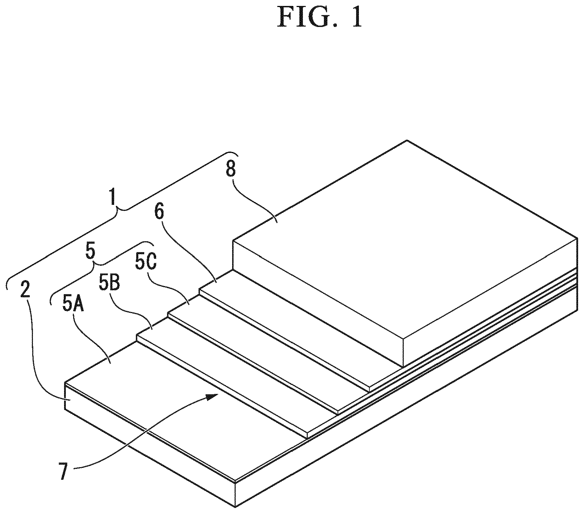

The structure of the superconducting wire of the present embodiment is not particularly limited; however, as shown in FIG. 1, a superconducting wire 1 includes such as a tape-shaped base material 2, an intermediate layer 5, a superconducting layer 6, and the stabilizing layer 8, as an example. The base material 2, the intermediate layer 5, and the superconducting layer 6 constitute the laminated body 7.

The base material 2 is a tape-shaped metallic base material, and having a main surface at each side in a thickness direction. As specific examples of the metal constituting the base material, a nickel-based alloy represented by HASTELLOY (registered trademark), stainless steel, an oriented metal substrate such as an oriented Ni-W substrate obtained by introducing a texture into a nickel alloy or the like may be used. The thickness of the base material may be appropriately adjusted according to the purpose, for example, in the range of 10-500 µm.

The intermediate layer 5 includes a diffusion prevention layer, an orientation layer, and a cap layer in sequence from the base material toward the superconducting layer. The orientation layer is preferably made of metal oxide which functions as a buffer layer which controls crystallinity of the oxide superconducting layer 6, prevents metal elements in the base material 2 from diffusing to a side the oxide superconducting layer 6, and eases the difference of physical characteristics (coefficient of thermal expansion, lattice constant and the like) between the base material 2 and the oxide superconducting layer 6. The intermediate layer 5, as an example, can be a laminate structure of the diffusion prevention layer 5A, the orientation layer 5B, and the cap layer 5C. The diffusion prevention layer 5A may be a single-layer structure or a multi-layer structure together with a bed layer. The orientation layer 5B and the cap layer 5C also may be a single-layer structure or a multi-layer structure.

The diffusion prevention layer 5A is constituted from, for example, Si₃N₄, Al₂O₃, GZO(Gd₂Zr₂O₇) and the like. The thickness of the diffusion preventing layer is, for example, 10-400 nm.

The orientation layer 5B is formed of a material that is oriented along two axes to control crystallinity of the cap layer 5C thereon. As a material of the orientation layer, for example, a metal oxide such as Gd₂Zr₂O₇, MgO, ZrO₂-Y₂O₃ (YSZ), SrTiO₃, CeO₂, Y₂O₃, Al₂O₃, Gd₂O₃, Zr₂O₃, Ho₂O₃, Nd₂O₃, or the like may be exemplified. The orientation layer is preferably formed by an ion-beam-assisted deposition (IBAD) method.

The cap layer 5C is formed on the surface of the above-mentioned orientation layer 5B and formed of a material in which crystal grains can be self-oriented in an in-plane direction. As a material of the cap layer 5C, for example, CeO₂, Y₂O₃, Al₂O₃, Gd₂O₃, ZrO₂, YSZ, Ho₂O₃, Nd₂O₃, LaMnO₃, or the like are exemplary examples. The thickness of the cap layer 5C is, for example, 50 to 5000 nm.

In a laminate structure of the intermediate layer 5, on the diffusion prevention layer 5A, a bed layer can be formed that is used to reduce an interface reaction and obtain orientation of the film formed on the bed layer. As a material of the bed layer, for example, Y₂O₃, Er₂O₃, CeO₂, Dy₂O₃, Eu₂O₃, Ho₂O₃, La₂O₃, or the like are exemplary examples. The thickness of the bed layer is, for example, 10 to 100 nm.

The superconducting layer 6 includes an oxide superconductor including a rare earth element. The superconducting layer 6 of the present embodiment includes an oxide superconductor having a composition expressed by REₐBa_{b}Cu₃O₇₋ₓ (RE represents one rare earth or a combination of two or more of a rare earth, a satisfies 1.05 ≤ a ≤ 1.35, b satisfies 1.80 ≤ b ≤ 2.05, and x represents the amount of oxygen deficiency).

Furthermore, in the oxide superconductor of the present embodiment, a non-superconducting phase having an outer diameter of 30 nm or less is included in a superconducting phase. The composition described above is an average composition of the superconducting phase and the non-superconducting phase. The average composition can be quantified by inductively coupled plasma (ICP) emission spectrometry and the like regarding a solution obtained by dissolving the oxide superconductor (superconducting layer). The outer diameter of the particles can be measured by an observation using an atomic force microscope (AFM), a transmission electron microscope (TEM), a scanning transmission electron microscope (STEM) or the like. In addition, for the composition analysis of the particles, an energy dispersive X-ray spectrometer (EDS) and the like can be used.

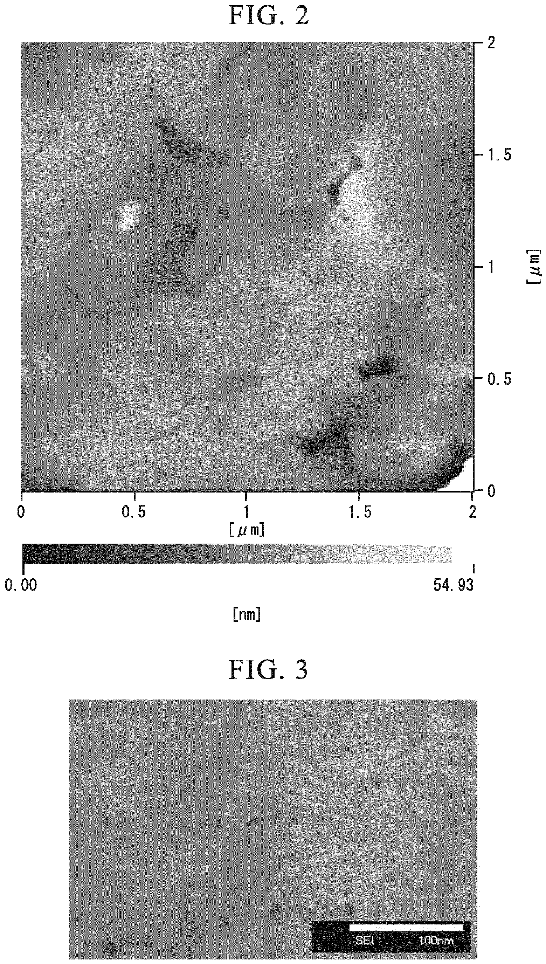

In Fig. 2, an example of a micrograph (2 µm × 2 µm) obtained by observing a portion of the oxide superconductor of the present embodiment (RE = Gd) using AFM is shown. Darkness and brightness of the micrograph shows a surface profile (unevenness in the height direction) of the sample corresponding to the bar of 0.00-54.93 nm. According to the micrograph of Fig. 2, crystal grains of GdBCO are observed as particles having an outer diameter of approximately 0.5-1 µm. Furthermore, on each surface of these crystal grains of GdBCO, it is observed that fine particles including an RE component and having the outer diameter of 30 nm or less are introduced and dispersed.

In Fig. 3, an example of a micrograph obtained by observing a portion of the above-described oxide superconductor (RE = Gd) using STEM is shown. In Fig. 3, the vertical direction of the drawing corresponds to the height direction (film-formation direction or laminating direction) and Fig. 3 shows an interlayer profile. In other words, whereas Fig. 2 shows a surface of the sample, Fig. 3 shows a cross-section of the sample. Based on Fig. 3, it is observed that a plurality of fine particles having the outer diameter of 30 nm or less is arranged along a plurality of directions (multiple layers) substantially perpendicular to the film-formation direction. In other words, it is seen that the plurality of fine particles are introduced and dispersed over a plurality of planes substantially parallel to the surface of the base material or substantially perpendicular to the film-formation direction. Since the sample is manufactured by using a pulse laser deposition method described later, a distance between the fine particles in the film-formation direction may be considered as a film-formation distance created by pulses. The fine particles can be observed on a film after the film formation is completed and a distance between the surfaces where the fine particles are dispersed (distance in a film formation direction) corresponds to a film thickness formed in one turn. Therefore, it can be considered that the particles are dispersed on the plurality of surfaces because when the film is formed by a laser, the base material is turned to pass through a jet flow (plume) at a plurality of times.

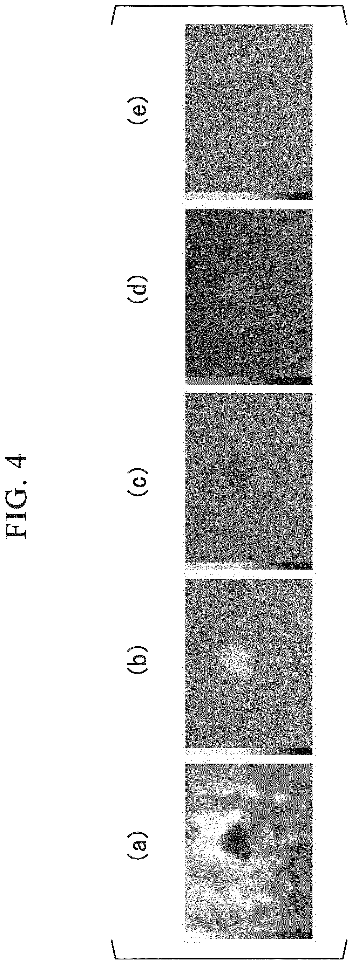

In Figs. 4(b)-4(e), micrographs obtained by analyzing the above observed particles (Fig. 4 (a)) by EDS are shown. Fig. 4(b) shows a detection result of Gd, Fig. 4(c) shows a detection result of Ba, Fig. 4(d) shows a detection result of Cu, and Fig. 4(e) shows a detection result of the O. Based on the results, since the elements of Gd, Ba, and Cu are detected, it is clear that the particles at least include Gd, Ba, and Cu. Therefore, it is understood that substances having components which is similar to components constituting the superconducting phase included in the superconducting layer are introduced into the superconducting layer.

Moreover, based on the difference in grayscale in each image, it is understood that the Gd composition of the particles is greater than that of the superconducting phase in Fig. 4(b), the Ba composition of the particles is less than that of the superconducting phase in Fig. 4(c), and the Cu composition of the particles is greater than that of the superconducting phase in Fig. 4(d).

As a rare earth element RE included in an oxide superconducting body of the present embodiment, exemplary examples include one or two or more kinds of Sc, Y, La, Ce, Pr, Nd, Pm, Sm, Eu, Gd, Tb, Dy, Ho, Er, Tm, Yb and Lu. Among these, one or a combination of two or more of Y, Gd, Eu and Sm may be preferable. The thickness of the superconducting layer is, for example, about 0.5 to 5 µm. The thickness is preferably uniform in the longitudinal direction. The amount of oxygen deficiency x is, for example, about 0.0 to 0.5.

In the oxide superconductor of the present embodiment, the particles of the non-superconducting phase are formed when the oxide superconductor of the average composition described above is formed. As a film formation method, for example, a pulse laser deposition method (PLD method) can be used. By dispersing the particles of the fine non-superconducting phase in the superconducting phase (see Figs. 2 and 3), unlike the case of introducing the artificial pinning centers, Ic in the magnetic field having a low temperature can be increased without decreasing the base Ic. When the coarse particles (for example, several tens to several hundreds µm) are dispersed in the superconducting phase, it is important to refine the particles since the characteristics are decreased as a result of the current path being inhibited by the coarse particles.

When forming the oxide superconducting layer by a PLD method, the film formation apparatus (laser deposition apparatus) directs a jet flow (plume) of constituent particles sputtered or evaporated from the target by the laser beam to the base material or the laminate including the base material so as to deposit the constituent particles, thereby form a superconducting layer. Therefore, the film formation apparatus includes a target, a base-material travelling apparatus, a processing chamber, and a laser light source.

As the target, a sintered body of a composite oxide having an identical or similar composition to the superconducting layer, a sintered body including a large amount of components that are easily removed during the formation of a film, or a plate material such as a metal, an alloy, ceramics, and a superconductor can be used. The target preferably has a uniform composition. Conventionally, regarding a target, the crystal particles such as BaSnO₃(BSO), BaZrO₃(BZO), BaHfO₃(BHO), BaTiO₃(BTO), SnO₂, TiO₂, ZrO₂, LaMnO₃, or ZnO is incorporated into the target as a material (foreign substance) which is a base of an artificial pinning center, and the superconducting layer including artificial pinning centers is formed. However, it is difficult to uniformly disperse the artificial pinning cneters in the superconducting layer. In particular, in the method utilizing a liquid phase such as a metal organic decomposition method (MOD method), the result easily relies on the conditions such as the preparation of the raw material liquid, coating, and drying, and uniform dispersion is not easy.

The particles of the non-superconducting phase dispersed according to the present embodiment are composed of one of the elements of RE, Ba, and Cu or compounds of two or more of the elements that are derived from the materials of the oxide superconductor. In one example, a 211-based oxide which has a higher RE ratio than in a general RE123-based superconductor or an oxide of RE and Ba are highly included. However, other elements may be included as unavoidable impurities.

The base material may include an intermediate layer and the like on the surface thereof (surface on the side where the superconducting layer is formed) as described above. When the substrate has a tape-shape, in order for the base material to travel in the longitudinal direction, it is preferable to provide a traveling apparatus. The traveling apparatus may include a supply reel feeding the base material, a take-up reel taking up the base material, and one or more turning member guiding the base material while turning the base material. The turning member is, for example, a reel supported by a support shaft. The base material may be a single crystal substrate or a laminate. By using such a traveling apparatus, the base material is turned and passed through the plume at a plurality of times to form a film, and the film thickness of the superconducting layer can be increased.

The target, the substrate and the traveling apparatus are stored in the processing chamber such as a vacuum chamber. The processing chamber has airtightness and a pressure resistance because the inside is in a high vacuum state. In order to control the temperature of the film formation space including an area and a peripheral portion thereof where plume occurs between the target and the base material, a temperature controller such as a heater box can be provided in the processing vessel. When heating the film formation space, the heating unit can be a hot plate, an electric heater, and the like. Here, the heating units are arranged so as to face the surface of the base material. That is, in the present embodiment, the heating unit directly heats the surface on which the base material is formed. Thus, it is possible to stably control the temperature of the film formation surface of the base material in an optimized temperature for the film formation.

The processing chamber includes a gas supplier introducing a gas into the inside and an exhaust unit exhausting the inside gas. As the gas, an atmospheric gas, a carrier gas, and a reactive gas or the like can be exemplified.

The laser light source applies a laser beam to the target. When the laser light source is provided at the outside of the processing chamber, a portion of the processing chamber is provided with a window which transmits the laser light. Between the window and the target, optical components such as a condenser lens can be provided. The target may be transferred during the film formation. For example, the target can be rotated or reciprocated together with a target holder supporting the target. As the laser light source, it is possible to use those which show a good energy output as a pulse laser such as an excimer laser and a YAG laser. For example, a laser light source having a pulse frequency of approximately 100-1200 Hz and an energy density of 0.1-50 J/cm² can be used. The energy of the laser to be incident on the target may be adjusted. For example, in certain conditions, when changing the energy (mJ), the outer diameter (nm) of the particles of the non-superconducting phase was as follows: 12 nm when 150 mJ, 25 nm when 200 mJ, 30 nm when 250 mJ, 38 nm when 300 mJ, and 42 nm when 350mJ.

In the superconducting wire 1 where the superconducting layer 6 is laminated on the substrate 2 as described above, a variety of configurations can be added. For example, the stabilizing layer 8 has a function of bypassing overcurrent that occurs in an accident, suppressing the occurrence of a chemical reaction between the oxide superconducting layer 6 and the layer formed thereon, or the like.

A material of the stabilizing layer 8 can be, for example, Ag, Cu, or alloys thereof. The stabilizing layer 8 can be laminated on the superconducting layer 6 or can surround the periphery of the superconducting layer 6 in a C-shape. Although in Fig. 1, the stabilizing layer 8 is depicted as a single layer, for example, the stabilizing layer 8 may have a laminate structure formed by laminating two or more layers including the material described above. The stabilizing layer 8 is not limited to be formed on the surfaces of the oxide superconducting layer 6, and may be formed on an outer surface of the base material 2 of the laminate 7 and on the entire surfaces including side faces of the laminate 7. In addition, there may be portions that the stabilizing layer 8 is not formed on a portion of the circumferential surface of the laminate 7.

Moreover, in superconducting wire 1, a protective layer, a solder layer, a resin layer and an insulating layer can be provided. The form of using the superconducting wire 1 is not particularly limited, and specific examples include a linear (tape) form, a coiled form, a cable form, and the like.

According to the present embodiment, (1) by shifting the composition of the oxide superconductor constituting the superconducting layer from the composition of general RE123-based superconductor, the fine particles of the non-superconducting phase is dispersed in the superconducting phase to promote the element substitution, and therefore, a magnetic-field capture at a low temperature can be promoted. In addition, (2) by increasing the crystallinity, high Ic in the self-magnetic field can be maintained. As a result, (3) Ic in the magnetic field having a low temperature can be kept high.

By irradiating the laser to the target to manufacture the above-described oxide superconductor, upon keeping the state of the target always constant and controlling the irradiation conditions of the laser, particles of a non-superconducting phase can be introduced into the superconducting layer.

### EXAMPLES

Hereinbelow, the present invention will be described in detail in Examples.

A tape-shape substrate (PLD-CeO₂/IBAD-MgO/Y₂O₃/Al₂O₃/Hastelloy) in which on a tape-shape base material formed of Hastelloy (trade name registered to Hanes International of the U.S.), a diffusion prevention layer of Al₂O₃, a bed layer of Y₂O₃, an orientation layer of MgO by the IBAD method, and a cap layer of CeO₂ by the PLD method was prepared. The tape-shape substrate was travelled from a reel to a reel, the target made of ReBCO (RE, oxides of Ba and Cu) was used, and an ReBCO film was formed on the cap layer by the PLD method. The film formation conditions were, for example, as follows: light source: excimer laser (KF: 248 nm), 0.5-10 J/cm² (300mJ), distance between the target and the substrate (T-S): 7cm, linear velocity of the tape-shape substrate: 40 m/h, pulse frequency: 200 Hz, oxygen partial pressure in processing vessel: PO₂ = 40 Pa, and temperature of heating device (hot plate): 910 °C. However, the film formation conditions were examples, and in the manufacturing examples described below, different film formation conditions were used in some cases.

The critical current Ic (unit A), the critical temperature Tc (unit K), the ratio of Ic, and the maximum diameter of the particles measured by AFM or TEM (unit nm) when the thickness of the obtained superconducting layer was 1.5 µm, are shown in Table 1 to 10.

Regarding the compositions, RE, a and b in the general expression of "REₐBa_{b}Cu₃O₇₋ₓ" are shown in Tables 1, 2, 4, 5 and 7-10, and the RE elements and the ratio of RE:Ba:Cu (if the artificial pinning centers were added, the materials and the weight percentage thereof follows to the symbol "+") are described in Tables 3 and 6.

Regarding the ratio of Ic, when b is constant (Tables 1, 4, 7, and 9), Ic of the composition having minimum a is a reference (1.0), and when a is constant (Tables 2, 5, 8, and 10), Ic of the composition having minimum b is a reference (1.0). Regarding the measurement conditions of Ic, the temperature was 77K, 50K or 20K, and the magnetic field was in the self-magnetic field (self) or 3T. The maximum diameter of the particles is shown in the column of "Diameter (nm)" in the table, and is denoted "None" when the particles are not observed.

In Tables 1 to 3, RE = Y. In Table 1, b = 1.95 and values of a are different. In Table 2, a = 1.3 and values of b are different. In Table 3, an example of Y123 (Y:Ba:Cu = 1:2:3) and an example of adding BZO (BaZrO₃) as an artificial pinning center are shown, and it is found that the characteristics do not change greatly even when the artificial pinning centers are introduced.

**Table 1**

| Composition | RE | Y | Y | Y | Y | Y | Y | Y | Y | Y | Y |
|---|---|---|---|---|---|---|---|---|---|---|---|
| | a | 1.60 | 1.57 | 1.53 | 1.40 | 1.35 | 1.21 | 1.17 | 1.09 | 1.05 | 1.00 |
| | b | 1.95 | 1.95 | 1.95 | 1.95 | 1.95 | 1.95 | 1.95 | 1.95 | 1.95 | 1.95 |
| Ic(A) | 77K (self) | 532 | 573 | 650 | 702 | 721 | 734 | 733 | 763 | 761 | 792 |
| | 77K (3T) | 10 | 13 | 23 | 31 | 29 | 35 | 32 | 33 | 30 | 31 |
| | 50K (self) | 1760 | 1892 | 1897 | 2422 | 2532 | 2453 | 2675 | 2421 | 2432 | 1987 |
| | 50K (3T) | 321 | 432 | 492 | 505 | 556 | 578 | 551 | 547 | 542 | 398 |
| | 20K (self) | 3540 | 4432 | 5021 | 5210 | 5192 | 5492 | 5432 | 5098 | 4998 | 3987 |
| | 20K (3T) | 1230 | 1301 | 1543 | 1650 | 1732 | 1800 | 182 | 1772 | 1655 | 1001 |
| Tc(K) | | 85.1 | 86.0 | 86. 2 | 87.3 | 87.9 | 88.4 | 88.5 | 88.9 | 88.8 | 89.1 |
| Ratio | 77K (self) | 0.7 | 0.7 | 0.8 | 0.9 | 0.9 | 0.9 | 0.9 | 1.0 | 1.0 | 1.0 |
| | 77K (3T) | 0.3 | 0.4 | 0.7 | 1.0 | 0.9 | 1.1 | 1.0 | 1.1 | 1.0 | 1.0 |
| | 50K (self) | 0.9 | 1.0 | 1.0 | 1.2 | 1.3 | 1.2 | 1.3 | 1.2 | 1.2 | 1.0 |
| | 50K (3T) | 0.8 | 1.1 | 1.2 | 1.3 | 1.4 | 1.5 | 1.4 | 1.4 | 1.4 | 1.0 |
| | 20K (self) | 0.9 | 1.1 | 1.3 | 1.3 | 1.3 | 1.4 | 1.4 | 1.3 | 1.3 | 1.0 |
| | 20K (3T) | 1.2 | 1.3 | 1.5 | 1.6 | 1. 7 | 1.8 | 1.8 | 1.8 | 1.7 | 1.0 |
| Diameter (nm) | AFM or TEM | 52 | 48 | 43 | 35 | 30 | 25 | 12 | 9 | 5 | None |

**Table 2**

| Composition | RE | Y | Y | Y | Y | Y | Y |
|---|---|---|---|---|---|---|---|
| | a | 1.3 | 1.3 | 1.3 | 1.3 | 1.3 | 1.3 |
| | b | 1.71 | 1.80 | 1.95 | 2.00 | 2.05 | 2.10 |
| Ic(A) | 77K (self) | 543 | 632 | 720 | 700 | 645 | 530 |
| | 77K (3T) | 23 | 29 | 30 | 34 | 22 | 16 |
| | 50K (self) | 1643 | 2034 | 2672 | 2532 | 2013 | 1040 |
| | 50K (3T) | 423 | 599 | 624 | 576 | 502 | 301 |
| | 20K (self) | 3432 | 4987 | 5492 | 4989 | 4065 | 2998 |
| | 20K (3T) | 987 | 1543 | 1973 | 1765 | 1642 | 893 |
| Tc (K) | | 85.9 | 86.1 | 87.1 | 88.6 | 88.1 | 87.8 |
| Ratio | 77K (self) | 1.0 | 1.2 | 1.3 | 1.3 | 1.2 | 1.0 |
| | 77K (3T) | 1.0 | 1.3 | 1.3 | 1.5 | 1.0 | 0.7 |
| | 50K (self) | 1.0 | 1.2 | 1.6 | 1.5 | 1.2 | 0.6 |
| | 50K (3T) | 1.0 | 1.4 | 1.5 | 1.4 | 1.2 | 0.7 |
| | 20K (self) | 1.0 | 1. 5 | 1.6 | 1.5 | 1.2 | 0.9 |
| | 20K (3T) | 1.0 | 1.6 | 2.0 | 1.8 | 1.7 | 0.9 |
| Diameter (nm) | AFM or TEM | 21 | 23 | 23 | 28 | 24 | 24 |

**Table 3**

| Composition | RE:Ba:Cu | Y:Ba:Cu=1:2:3 | Y:Ba:Cu=1.3:1.95:3+BZ0(5mass%) |
|---|---|---|---|
| Ic (A) | 77K (self) | 700 | 692 |
| | 77K (3T) | 28 | 59 |
| | 50K (self) | 1987 | 2982 |
| | 50K (3T) | 421 | 634 |
| | 20K (self) | 3129 | 4021 |
| | 20K (3T) | 1200 | 1891 |
| Tc(K) | | 89.0 | 88.5 |

In Tables 4 to 6, RE = Gd. In Table 4, b = 1.95 and the values of a are different. In Table 5, a = 1.3 and the values of b are different. Table 6 shows an example of Gd123 (Gd:Ba:Cu = 1:2:3) and an example in which BZO (BaZrO₃) is added as an artificial pinning center.

**Table 4**

| Composition | RE | Gd | Gd | Gd | Gd | Gd | Gd | Gd | Gd | Gd | Gd |
|---|---|---|---|---|---|---|---|---|---|---|---|
| | a | 1.62 | 1.58 | 1.54 | 1.41 | 1.35 | 1.31 | 1.20 | 1.11 | 1.05 | 1.01 |
| | b | 1.95 | 1.95 | 1.95 | 1.95 | 1.95 | 1.95 | 1.95 | 1.95 | 1.95 | 1.95 |
| Ic (A) | 20K (3T) | 1532 | 1672 | 1989 | 1982 | 2245 | 2243 | 2342 | 2101 | 2096 | 1343 |
| Tc (K) | | 87.1 | 87.5 | 87.9 | 88. 5 | 90.6 | 90.9 | 91.7 | 92.7 | 93.0 | 93.1 |
| Ratio | 20K (3T) | 1.1 | 1.2 | 1.5 | 1.5 | 1.7 | 1.7 | 1.7 | 1.6 | 1.6 | 1 |
| Diameter (nm) | AFM or TEM | 55 | 40 | 42 | 35 | 30 | 23 | 19 | 14 | 9 | None |

**Table 5**

| Composition | RE | Gd | Gd | Gd | Gd | Gd | Gd |
|---|---|---|---|---|---|---|---|
| | a | 1.3 | 1.3 | 1.3 | 1.3 | 1.3 | 1.3 |
| | b | 1.70 | 1.80 | 1.96 | 2.01 | 2.05 | 2.11 |
| Ic (A) | 20K (3T) | 1331 | 1873 | 2345 | 2564 | 2652 | 1439 |
| Tc (K) | | 89.9 | 91.2 | 91.6 | 92.0 | 91.6 | 90.1 |
| Ratio | 20K (3T) | 1.0 | 1.4 | 1.8 | 1.9 | 2.0 | 1.1 |
| Diameter (nm) | AFM or TEM | 18 | 19 | 20 | 19 | 17 | 19 |

**Table 6**

| Composition | RE:Ba:Cu | Gd:Ba:Cu=1:2:3 | Gd:Ba:Cu=1.3:1.95:3+BZ0 (5mass%) |
|---|---|---|---|
| Ic (A) | 20K (3T) | 1232 | 2432 |
| Tc (K) | | 93.1 | 91.8 |

In Tables 7 and 8, RE = Eu. In Table 7, b = 1.95 and the values of a are different. In Table 8, a = 1.3 and the values of b are different.

**Table 7**

| Composition | RE | Eu | Eu | Eu | Eu | Eu | Eu | Eu | Eu | Eu | Eu |
|---|---|---|---|---|---|---|---|---|---|---|---|
| | a | 1.59 | 1.56 | 1.43 | 1.35 | 1.30 | 1.21 | 1.16 | 1.08 | 1.05 | 1.00 |
| | b | 1.95 | 1.95 | 1.95 | 1.95 | 1.95 | 1.95 | 1.95 | 1.95 | 1.95 | 1.95 |
| Ic (A) | 20K (3T) | 1533 | 1723 | 1749 | 1873 | 1921 | 2012 | 2012 | 1904 | 1853 | 1120 |
| Tc (K) | | 87.1 | 87.7 | 88.5 | 90.1 | 90.4 | 91.8 | 92.2 | 92.6 | 92.5 | 93.0 |
| Ratio | 20K (3T) | 1.4 | 1.5 | 1.6 | 1.7 | 1.7 | 1.8 | 1.8 | 1.7 | 1.7 | 1 |
| Diameter (nm) | AFM or TEM | 43 | 40 | 34 | 30 | 21 | 23 | 19 | 10 | 6 | None |

**Table 8**

| Composition | RE | Eu | Eu | Eu | Eu | Eu | Eu |
|---|---|---|---|---|---|---|---|
| | a | 1.3 | 1.3 | 1.3 | 1.3 | 1.3 | 1.3 |
| | b | 1.70 | 1.80 | 1.94 | 2.01 | 2.05 | 2.12 |
| Ic (A) | 20K (3T) | 1439 | 1983 | 2003 | 2121 | 2012 | 1532 |
| Tc (K) | | 89.6 | 91.4 | 92.2 | 92.9 | 92.4 | 91.6 |
| Ratio | 20K (3T) | 1.0 | 1.4 | 1.4 | 1.5 | 1.4 | 1.1 |
| Diameter (nm) | AFM or TEM | 22 | 19 | 20 | 20 | 17 | 18 |

In Tables 9 and 10, RE = Sm. In Table 9, b = 1.95 and the values of a are different. In Table 10, a = 1.3 and the values of b are different.

**Table 9**

| Composition | RE | Sm | Sm | Sm | Sm | Sm | Sm | Sm | Sm | Sm | Sm |
|---|---|---|---|---|---|---|---|---|---|---|---|
| | a | 1.59 | 1.55 | 1.41 | 1.35 | 1.32 | 1.20 | 1.16 | 1.07 | 1.05 | 1.01 |
| | b | 1.95 | 1.95 | 1.95 | 1.95 | 1.95 | 1.95 | 1. 95 | 1.95 | 1.95 | 1.95 |
| Ic (A) | 20K (3T) | 1324 | 1673 | 1783 | 1898 | 2012 | 2021 | 2132 | 1983 | 1853 | 1120 |
| Tc (K) | | 87.1 | 87.8 | 88.1 | 89.1 | 90.1 | 91.9 | 92.1 | 92.8 | 92.8 | 93.2 |
| Ratio | 20K (3T) | 1.2 | 1.5 | 1.6 | 1.7 | 1.8 | 1.8 | 1.9 | 1.8 | 1.7 | 1 |
| Diameter (nm) | AFM or TEM | 45 | 40 | 35 | 30 | 25 | 27 | 14 | 11 | 7 | None |

**Table 10**

| Composition | RE | Sm | Sm | Sm | Sm | Sm | Sm |
|---|---|---|---|---|---|---|---|
| | a | 1.3 | 1.3 | 1.3 | 1.3 | 1.3 | 1.3 |
| | b | 1.71 | 1.80 | 1.95 | 2.00 | 2.05 | 2.10 |
| Ic (A) | 20K (3T) | 1543 | 1921 | 2321 | 2113 | 2001 | 1232 |
| Tc (K) | | 89.7 | 91.6 | 92.3 | 92.9 | 92.8 | 91.7 |
| Ratio | 20K (3T) | 1.0 | 1.2 | 1.5 | 1.4 | 1.3 | 0.8 |
| Diameter (nm) | AFM or TEM | 23 | 24 | 21 | 22 | 22 | 24 |

Based on the results described above, when 1.05 ≤ a ≤ 1.35 and 1.80 ≤ b ≤ 2.05 are satisfied, in the structure in which the particles having the maximum outer diameter of 30 nm or less are dispersed, it is confirmed that the superconductor having a high Ic even in the magnetic field having a low temperature can be obtained.

### DESCRIPTION OF THE REFERENCE SYMBOLS

1: Oxide superconducting wire
2: Base material
5: Intermediate layer
6: Oxide superconducting layer
7: Laminate
8: Stabilizing layer

## Claims

1. An oxide superconductor having a composition expressed by REₐBa_{b}Cu₃O₇₋ₓ, where RE represents one rare earth or a combination of two or more of a rare earth, a satisfies 1.05 ≤ a ≤ 1.35, b satisfies 1.80 ≤ b ≤ 2.05, and x represents an amount of oxygen deficiency,
wherein a non-superconducting phase having an outer diameter of 30 nm or less is included in a superconducting phase.

2. The oxide superconductor according to claim 1, wherein the RE is one or a combination of two or more of Y, Gd, Eu and Sm.

3. An oxide superconducting wire comprising a base material, an intermediate layer, an oxide superconducting layer comprising the oxide superconductor according to claim 1 or 2, and a stabilization layer, which are sequentially laminated.

4. The oxide superconducting wire according to claim 3, wherein the non-superconducting phase is dispersed on a plane orthogonal to a laminate direction.

5. A method of manufacturing the oxide superconducting wire according to claim 3 or 4, the method comprising
forming the oxide superconductor on a film formation surface of the base material by a pulse laser deposition method.

6. The method of manufacturing the oxide superconducting wire according to claim 5, the method comprising direct heating the film formation surface during forming the oxide superconductor.
